# EUROPÄISCHE PATENTSCHRIFT

(11) **EP 1 333 570 B1**
(45) Veröffentlichungstag und Bekanntmachung des Hinweises auf die Patenterteilung: **19.04.2006**
(21) Anmeldenummer: 03001909.5
(22) Anmeldetag: 30.01.2003
(51) Int. Cl.: H02M 7/48, H02M 1/00

(54) **Schaltungsanordnung und Verfahren zum Messen und Begrenzen von Strömen**
Method and circuit arrangement for current measuring and limitation
Procédé et circuit pour mésurer et limiter des courants

(30) Priorität: 31.01.2002 DE 10203813
(43) Veröffentlichungstag der Anmeldung: 06.08.2003
(73) Patentinhaber: Diehl AKO Stiftung & Co. KG, 88239 Wangen (DE)
(72) Erfinder: Weinmann, Martin, 88339 Bad Waldsee (DE)
(74) Vertreter: Diehl Patentabteilung

(56) Entgegenhaltungen:
- EP-A- 0 977 337
- DE-A- 19 838 974

## Beschreibung

Die Erfindung betrifft ein Verfahren gemäß dem Anspruch 1.

Aus der DE 198 38 974 A1 ist eine elektrische Schaltung mit einer Vorrichtung zur Erfassung einer Stromgröße bekannt, bei der kein separater Messwiderstand, sondern eine bereits vorhandene Stanzgitterverbindung als elektrische Leitungsverbindung zwischen zwei Bauteilen der elektrischen Schaltung selbst verwendet wird.

Die EP 0 977 337 A2 beschreibt eine gattungsgemäße Schaltungsanordnung mit darauf aufbauendem Verfahren zur Messung der Ströme eines aus einem Spannungszwischenkreis gespeisten Umrichters zur Ansteuerung von Motoren, bei der mit demselben Mittel zur Strommessung sowohl die Phasenströme des Motors gemessen werden können als auch die Stromaufnahme des Umrichters aus dem Versorgungsnetz.

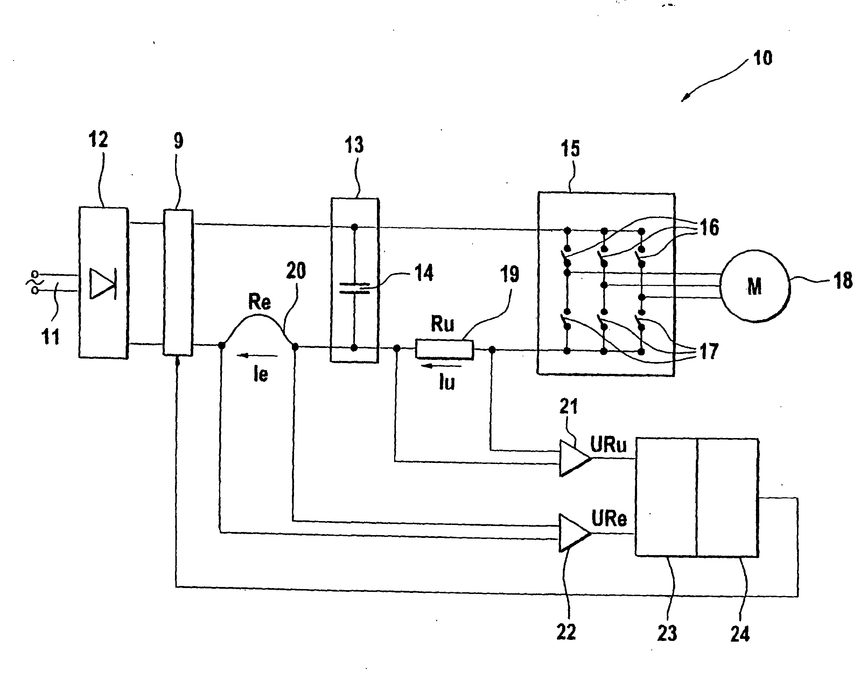

Gattungsgemäße Maßnahmen sind auch aus der DE 198 34 315, dort Figur 6, bekannt. Eine ans Netz angeschlossene Gleichrichterbrücke speist über einen Gleichspannungs-Zwischenkreis sowie einen sechspulsigen Umrichter einen dreiphasigen Motor. Je ein Messwiderstand ist zwischen der Gleichrichterbrücke und dem Gleichspannungs-Zwischenkreis sowie zwischen diesem und dem Umrichter angeordnet. Der letztgenannte, im Energiefluß hintere Messwiderstand mißt den aus dem Gleichspannungs-Zwischenkreis entnommenen Umrichterstrom, der vordere Messwiderstand misst den aus dem Netz bezogenen Eingangsstrom. Dieser Eingangsstrom kann als Regelgröße mit Begrenzerfunktion für die Stromaufnahme aus dem Netz dienen. Dadurch lässt sich der Effektivstrom reduzieren, der Leistungsfaktor verbessern (sogenannte Power-Factor-Control, PFC) bzw. die Leistungsaufnahme aus dem Netz auf den Maximalwert begrenzen, der trotz momentan höheren Strombedarfes die Netzsicherung noch nicht auslösen lässt. Da dieser vordere Messwiderstand hohe Stromspitzen, insbesondere beim Aufladen eines entladenen Zwischenkreis-Kondensators, unbeschadet überstehen muß, ist hier ein impulsfester Widerstand einzusetzen, der einen sehr hohen Einzelstückpreis hat und aufgrund seiner Abmessungen regelmäßig nicht für eine Automatenbestückung der Schaltungsanordnung geeignet ist.

In Erkenntnis dieser Gegebenheiten liegt vorliegender Erfindung die technische Problemstellung zugrunde, für den Betrieb eines Antriebsmotors den aus einem

Umrichter über einen Gleichspannungs-Zwischenkreis bezogenen Netzstrom ohne das Erfordernis eines impulsfesten Widerstandes erfassen und gezielt beeinflussen zu können.

Diese Aufgabe ist erfindungsgemäß durch die in den Hauptansprüchen angegebenen wesentlichen Merkmale gelöst. Danach wird der Eingangsstrom vor dem Gleichspannungs-Zwischenkreis mittels des Spannungsabfalles über einer Leiterbahn der Schaltungsanordnung selbst erfaßt (wie es als solches aus der DE 198 38 974 A1 bekannt ist, wo aber nur eine - hier nicht ausreichende - relative Strombestimmung über die Schwankung des Spannungsabfalls möglich ist); und zum Erfassen des Ausgangsstromes, hinter dem Gleichspannungs-Zwischenkreis, für eine Absolutbestimmung des Eingangsstromes genügt ein herkömmlicher, kostengünstiger und problemlos verarbeitbarer Widerstand, wie z. B. ein SMD-Dickschichtwiderstand.

Der teure impulsfeste Meßwiderstand wird also durch eine ohnehin vorhandene Leiterbahn von zunächst unbekanntem Leitwert ersetzt. Der kann aber fortlaufend erfaßt werden, um temperatur- oder strukturbedingte Fehlereinflüsse für die Stromermittlung auszugleichen.

Die erfindungsgemäße Ermittlung des Absolutwertes des über einen Gleichspannungs-Zwischenkreis bezogenen Netzstromes beruht nun auf einer Spannungsmessung an einfachen Widerstandsstrukturen vor und hinter dem Gleichspannungs-Zwischenkreis mit einer Auswertung auf der Basis, daß der Zwischenkreis-Kondensator pro Netzperiode, also im Mittel soviel Ladung an den Umrichter abgibt, wie er zuvor aus dem Netz aufgenommen hat, weshalb ohne besondere Auslegungen für Impulsbelastbarkeit eines Eingangswiderstandes der Eingangsstrom einfach über das erfaßte Leiterbahnstück vor und der Ausgangsstrom über einen gewöhnlichen SMD-Dickschichtwiderstand hinter dem Gleichspannungs-Zwischenkreis rechnerisch als gleich groß angesetzt werden können.

Jeder dieser beiden Ströme kann nach dem Ohrnschen Gesetz durch Spannung und Widerstand beschrieben werden. Damit ergibt sich die zunächst unbestimmte Größe des Eingangsstrom-Widerstands des Leiterbahn aus der bekannten Größe des Ausgangsstrom-Widerstandes, bewertet (also multipliziert) mit dem Quotienten aus den aktuell gemessenen Spannungsabfällen an diesen beiden Widerständen. Wenn das Messen der Spannung an den beiden Widerständen kontinuierlich oder quasi-kontinuierlich erfolgt, ergibt das den aktuellen Periodenmittelwert des aufgenommenen Netzstromes.

Da der so ermittelte Eingangsstrom, der über Strombegrenzungsmaßnahmen beeinflußbar ist, den mittleren Absolutwert der Stromaufnahme aus dem Netz repräsentiert, führt das zu einer Korrekturmöglichkeit für den Leistungsfaktor, ohne dafür noch eines teuren impulsfesten Sonderwiderstandes zur Netzstrommessung zu bedürfen. Die erfindungsgemäße Netzstrommessung eröffnet so eine sehr preisgünstige aktive Leistungsfaktorsteuerung, wie sie europäische Versorgungsuntemehmen von ihren gewerblichen Abnehmern verlangen, bzw. wenigstens eine Begrenzung des aus dem Netz aufgenommenen Stromes auf einen deklarierten Wert unabhängig von der gerade wirksamen Netzimpedanz und dem damit verbundenen momentanen Leistungsfaktor, wie es die Anbieter von weniger stabil betriebenen Netzen (etwa in den USA) gegen Einräumen günstiger Sondertarife von ihren Abnehmern fordern.

Die erfindungsgemäße Maßnahe zum Bestimmen der absoluten mittleren Größe des von einem Umrichter über einen Gleichspannungs-Zwischenkreis aus dem Netz bezogenen Stromes ersetzt also den an sich erforderlichen impulsfesten Eingangsstrom-Messwiderstand durch eine bloße Leiterbahn unbekannten Widerstandes der Schaltungsanordnung selbst. Da aber der vom Gleichspannungs-Zwischenkreis aus dem Netz aufgenommene Eingangsstrom im Mittel gleich dem in den Umrichter abgegebenen Ausgangsstrom ist, ist der für die absolute Strommessung erforderliche aktuelle Widerstandswert der Leiterbahn gegeben durch den Widerstandswert des Messwiderstands hinter dem Gleichspannungs-Zwischenkreis, gewichtet mit dem Quotienten aus gemessenen Eingangs- und Ausgangs-Spannungsabfällen an den Widerständen. Damit kann eingangsseitig über einen Strombegrenzer oder lastseitig über einen Konverter eine Netzstrombeeinflussung und damit eine Strombegrenzung oder eine Leistungsfaktorbeeinflussung erfolgen, ohne eines teuren impulsfesten Sonderwiderstandes für das Messen der absoluten Größe des gerade aufgenommenen mittleren Netzstromes zu bedürfen.

Zusätzliche Weiterbildungen und weitere Merkmale und Vorteile der Erfindung ergeben sich aus den weiteren Ansprüchen und aus nachstehender Beschreibung eines in der Zeichnung unter Beschränkung auf das wesentliche skizzierten Blockschaltbildes einer bevorzugten schaltungstechnischen Realisierung der erfindungsgemäßen Lösung.

In der einzigen Figur der Zeichnung ist schematisch die vereinfachte Topologie einer zur Durchführung des erfindungsgemäßen Verfahrens ausgelegten Schaltungsanordnung 10 etwa zum Ermöglichen einer aktiven Leistungsfaktorkorrektur durch Steuern der Stromaufnahme aus einem Netz 11 skizziert. Über eine Gleichrichterbrücke 12, die ans Netz 11 angeschlossen ist, erfolgt die Aufladung eines in einem Gleichspannungs-Zwischenkreis 13 befindlichen Zwischenkreis-Kondensators 14. Hieraus wird, nach Maßgabe einer externen Ansteuerung von Schaltmitteln 16 und 17 in den Halbzweigen eines Umrichters 15, der ihm nachgeschaltete Drehfeld-Motor 18 gespeist und der Zwischenkreis-Kondensator 14 entsprechend entladen. Die etwa von einem Steuerprogramm oder von einem Regler bestimmte Laststeuerung (aus einer Steuervorrichtung 24, im Blockschaltbild nicht näher ausgeführt) über die Schaltmittel 16, 17 beeinflußt somit den Strombedarf aus dem Zwischenkreis 13 und bestimmt deshalb die Stromaufnahme aus dem Netz. Denn über die Gleichrichterbrücke 12 wird der Zwischenkreis-Kondensators 14 aus dem Netz 11 nachgeladen.

Der Ausgangsstrom aus dem Gleichspannungs-Zwischenkreis 13 fließt über einen hier als Messwiderstand 19 dienenden gewöhnlichen Widerstand, etwa einen SMD-Dickschichtwiderstand bekannter Größe Ru zum Umrichter. An diesem Widerstand 19 (Ru) erfolgt das indirekte Ermitteln des Stromes durch Messen eines Spannungsabfalls URu. Zwischen Gleichspannungs-Zwischenkreis 13 und Gleichrichterbrücke 12 ist ein in Energierichtung vorderer Widerstand 20 zum indirekten Messen eines Eingangsstromes Ie geschaltet. Dieser hier ermittelte Eingangsstrom le entspricht der Netzstromaufnahme zum Nachladen des Zwischenkreis-Kondensators 14, die auch über eine Strombegrenzer-Schaltung 9 beeinflußt werden kann.

Als Eingangsstrom-Messwiderstand 20 vor dem Gleichspannungs-Zwischenkreis 13 dient einfach eine Leiterbahn der Schaltung 10 selbst, an der ein Spannungsabfall URe gemessen wird. Der Quotient aus diesem Spannungsabfall URe und der Größe Re des Eingangsstrom-Messwiderstandes 20 ist der Eingangsstrom Ie.

Die an den Messwiderständen 19 bzw. 20 abgegriffenen kleinen Spannungsabfälle URu bzw. URe werden durch je einen Verstärker 21 bzw. 22 auf einen Verarbeitungspegel für einen Analog-Digital-Wandler 23 angehoben, der damit z.B. eine Steuervorrichtung 24 speist, welche den Strombegrenzer 9 steuert oder die Ansteuerung der Schaltmittel 16, 17 vor der Last (Motor 18) zur Begrenzung der gerade aufgenommenen Lastleistung beeinflußt, um ein Ansprechen der Überstromsicherung im Netzstromkreis zu vermeiden. Die Steuervorrichtung 24 enthält für die Stromberechnung und für solche vom aktuellen Strombedarf abhängig vorprogrammierte Einflußnahmen auf die Netzbelastung einen Micro-Controler.

In Abhängigkeit vom gemessenen Spannungsabfall URe zwischen dem Gleichspannungs-Zwischenkreis 13 und der Gleichrichterbrücke 12 kann die Stromaufnahme aus dem Netz 11 auch mittels einer gesonderten Schaltung 9 begrenzt werden. Für die Praxis wichtig ist, dass der Leistungsfaktor infolge Dämpfung der Oberwellen durch sinusförmige Stromaufnahme verbessert oder daß bei extremer Netzimpedanz die Effektivstromaufnahme aus dem Netz 11 auf einen gemäß einer Tarifvorgabe verabredeten und einer Überstromsicherung festgelegten Sollwert begrenzt wird, ohne die Sicherung schon zum Ansprechen zu bringen und dadurch den Lastbetrieb zu unterbrechen.

Um die nicht eindeutig bestimmte und nicht reproduzierbare Größe Re des Eingangsstrom-Messwiderstands 20 in Form eines bloßen Leiterbahnen-Abschnittes zu bestimmen und dadurch Fehler auszugleichen, die z.B. durch Schichtdickentoleranzen für die Leiterbahn, uneinheitliche Temperaturkoeffizienten, Oxidation, etc. bedingt sind, erfolgt die Messung des Spannungsabfalls URe, ebenso wie die Messung des Spannungsabfalls URu am Ausgangsstrom-Messwiderstand 19, wenigstens quasi-kontinuierlich. Aus diesen Messungen werden die integralen Mittelwerte der Spannungsabfälle an den Messwiderständen 19 und 20 während einer Netzperiode ermittelt, die durch den Reziprokwert der Netzfrequenz bestimmt sind.

Das Verfahren zur Netzstrommessung bedient sich also des Umstandes, dass (stationär betrachtet) eine über den Eingangsstrom-Messwiderstand 20 fließende Ladung zur Aufladung des Zwischenkreis-Kondensators 14 bei dessen darauffolgender Entladung zur Speisung des Umrichters 15 mit identischem Betrag über den Ausgangsstrom-Messwiderstand 19 wieder abfließt. Infolge dessen ist der Mittelwert des Stromflusses Ie über den Eingangsstrom-Messwiderstand 20 während einer Netzperiode gleich dem Mittelwert des Stromflusses Iu über den Ausgangsstrom-Messwiderstand 19 während einer Netzperiode.

Gemäß dem Ohmschen Gesetz wird der Periodenmittelwert des Stromflusses Ie bzw. Iu über einen der Messwiderstände 20 bzw. 19 durch den Quotienten aus dem Mittelwert des Eingangs-Spannungsabfalls URe bzw. des AusgangsSpannungsabfalls URu an dem Messwiderstand 20 bzw. 19 während einer Netzperiode und die Größe Re bzw. Ru des Messwiderstands 20 bzw. 19 beschrieben.

Wie oben ausgeführt, wird dazu der jeweilige Spannungsabfall URe und URu an den Messwiderständen 20 und 19 gemessen. Ebenfalls bekannt ist die Größe Ru des Ausgangsstrom-Messwiderstands 19. Zur Messung des Stromflusses le ist es jedoch erforderlich, dass der unbestimmte Wert Re des Eingangsstrom-Messwiderstands 20 ermittelt wird. Dies erfolgt durch eine Bewertung (Gewichtung, also Multiplikation) der Größe Ru des Ausgangsstrom-Messwiderstands 19 mit dem Quotienten aus aktuell gemessenen Periodenmittelwerten des Eingangs-Spannungsabfalls URe am Messwiderstand 20 und des AusgangsSpannungsabfalls URu am Messwiderstand 19.

In bevorzugter Weise wird der Spannungsabfall an den beiden Messwiderständen 19 und 20 kontinuierlich gemessen. Abhängig vom gemessenen Eingangs-Spannungsabfall URe zwischen dem Gleichspannungs-Zwischenkreis 13 und der Gleichrichterbrücke 12 kann die Stromaufnahme aus dem Netz 11 über einen Strombegrenzer 9 oder mittels entsprechender Ansteuerung der Schaltmittel 16, 17 durch Begrenzen der Motorleistung über den Konverter 15 reglementiert, also insbesondere begrenzt werden.

Als Ausgangsstrom-Messwiderstand 19 zur Messung des AusgangsSpannungsabfalls URu hinter dem Gleichspannungs-Zwischenkreis 13 kann ein problemlos zu bestückender, handelsüblicher SMD-Dickschichtwiderstand verwendet werden.

Erfindungsgemäß ersetzt also eine Schaltungsanordnung 10 zum Bestimmen des von einem Umrichter 15 über einen Gleichspannungs-Zwischenkreis 13 aus dem Netz 11 bezogenen Stromes Ie den an sich erforderlichen impulsfesten Eingangsstrom-Messwiderstand 20 durch eine Leiterbahn zunächst unbekannten Widerstandes der Schaltungsanordnung selbst. Da der vom Gleichspannungs-Zwischenkreis 13 aus dem Netz 11 aufgenommene Eingangsstrom le im Mittel gleich dem in den Umrichter 15 abgegebenen Ausgangsstrom lu ist, ist der aktuelle Widerstandswert Re der Leiterbahn gegeben durch den Widerstandswert Ru des Messwiderstands 19 hinter dem Gleichspannungs-Zwischenkreis 13, gewichtet mit dem Quotienten URe/URu aus Eingangs- und Ausgangsspannungsabfall. So kann über einen Strombegrenzer 9 oder über die Ansteuerung des Konverters 15 vor der Last 18 eine Netzstrombeeinflussung und damit eine Beeinflussung des Leistungsfaktors bzw. eine Begrenzung der Stromaufnahme erfolgen, ohne eines teuren impulsfesten Sonderwiderstandes für die Netzstrommessung zu bedürfen.

## Patentansprüche

1. Verfahren, zum Ermitteln des von einem Umrichter (15) über einen Gleichspannungs-Zwischenkreis (13) bezogenen Eingangsstromes (le) mittels Spannungsmessung an Messwiderständen (20, 19) vor und hinter dem Gleichspannungs-Zwischenkreis (13), wobei der Eingangsstrom (le) vor dem Gleichspannungs-Zwischenkreis (13) bestimmt wird als der Quotient aus Spannungsabfall (URe) und Größe (Re) des Eingangsstrom-Messwiderstands (20),
**dadurch gekennzeichnet,**
**dass** als Größe des Eingangsstrom-Messwiderstands (Re, 20), der selbst eine Leiterbahn ist, der bekannte Ausgangsstrom-Messwiderstand (Ru, 19) hinter dem Gleichspannungs-Zwischenkreis (13) gewichtet wird mit dem Quotienten (URe/URu) aus dem aktuell gemessenen Periodenmittelwert des Eingangs- und des Ausgangsspannungsabfalls.

2. Verfahren nach Anspruch 1,
**dadurch gekennzeichnet,**
**dass** die Messung des Spannungsabfalls an beiden Strommesswiderständen (19, 20) wenigstens quasi-kontinuierlich erfolgt.

3. Verfahren nach Anspruch 2,
**dadurch gekennzeichnet,**
**dass** in Abhängigkeit vom gemessenen Spannungsabfall (URe) zwischen dem Gleichspannungs-Zwischenkreis (13) und der Gleichrichterbrücke (12) die Stromaufnahme aus dem Netz (11) begrenzt wird, so dass der Leistungsfaktor infolge Dämpfung von Oberwellen durch sinusförmige Stromaufnahme verbessert wird oder auch bei extremer Netzimpedanz die Effektivstromaufnahme aus dem Netz (11) auf einen von der gegebenen Sicherung abhängigen Sollwert begrenzt wird.

4. Verfahren nach Anspruch 3,
**dadurch gekennzeichnet,**
**dass** der Spannungsabfall (URu) mittels des vom Gleichspannungs-Zwischenkreis (13) zum Umrichter (15) über einen SMD-Dickschichtwiderstand fließenden Stromes (lu) ermittelt wird.

5. Verfahren nach einem der Ansprüche 1 bis 4,
**dadurch gekennzeichnet,**
**dass** die Stromaufnahme aus dem Netz begrenzt wird durch eine Begrenzung der aufgenommenen Motorleistung, wenn der aus dem Netz bezogene Effektivstrom einen vom Ansprechen einer Sicherung abhängigen Grenzwert zu überschreiten droht.

## Claims

1. Method for determining the input current (Ie) drawn by an inverter (15) via a DC-voltage intermediate circuit (13) by means of measuring the voltage across measuring resistors (20, 19) upstream and downstream of the DC-voltage intermediate circuit (13), the input current (Ie) upstream of the DC-voltage intermediate circuit (13) being determined as the quotient of the voltage drop (URe) and the resistance (Re) of the input-current measuring resistor (20), **characterized in that**, as the resistance (Re) of the input-current measuring resistor (20), which itself is a conductor track, the known resistance (Ru) of the output-current measuring resistor (19) downstream of the DC-voltage intermediate circuit (13) is weighted with the quotient (URe/URu) from the presently measured period mean value for the input and output voltage drop.

2. Method according to Claim 1, **characterized in that** the measurement of the voltage drop across the two current measuring resistors (19, 20) takes place at least quasi-continuously.

3. Method according to Claim 2, **characterized in that** the current consumption from the mains (11) is limited as a function of the measured voltage drop (URe) between the DC-voltage intermediate circuit (13) and the rectifier bridge (12), with the result that the power factor is improved as a result of damping of harmonics by means of sinusoidal current consumption, or else with the result that, in the case of an extreme mains impedance, the rms current consumption from the mains (11) is limited to a desired value which is dependent on the fuse provided.

4. Method according to Claim 3, **characterized in that** the voltage drop (URu) is determined by means of the current (Iu) flowing from the DC-voltage intermediate circuit (13) to the inverter (15) via an SMD thick-layer resistor.

5. Method according to one of Claims 1 to 4, **characterized in that** the current consumption from the mains is limited by limiting the motor power consumed if the rms current drawn from the mains threatens to exceed a limit value dependent on the response of a fuse.

## Revendications

1. Procédé de détermination du courant d'entrée (Ie) consommé par un convertisseur (15) par l'intermédiaire d'un circuit intermédiaire (13) à tension continue, par mesure de la tension aux bornes de résistances de mesure (20, 19) situées en amont et en aval du circuit intermédiaire (13) à tension continue, le courant d'entrée (Ie) étant déterminé en amont du circuit intermédiaire (13) à tension continue en tant que quotient de la chute de tension (URe) et de la valeur (Re) de la résistance (20) de mesure du courant d'entrée, **caractérisé en ce que**, comme valeur de la résistance (Re, 20) de mesure du courant d'entrée, qui forme elle-même un parcours conducteur, on pondère la résistance connue (Ru, 19) de mesure du courant de sortie en aval du circuit intermédiaire (13) à tension continue par le quotient (URe/URu) des valeurs moyennes effectivement mesurées sur une période de la chute de tension d'entrée et de la chute de tension de sortie.

2. Procédé selon la revendication 1, **caractérisé en ce que** la mesure de la chute de tension sur les deux résistances (19, 20) de mesure du courant s'effectue de manière au moins quasi continue.

3. Procédé selon la revendication 2, **caractérisé en ce qu'**en fonction de la chute de tension (URe) mesurée entre le circuit intermédiaire (13) à tension continue et le pont redresseur (12), le prélèvement de courant sur le réseau (11) est limité de telle sorte que le facteur de puissance soit amélioré par amortissement des harmoniques lors d'un prélèvement de courant sinusoïdal ou, lorsque l'impédance du réseau est extrême, en limitant le prélèvement de courant efficace sur le réseau (11) à une valeur de consigne qui dépend de la protection donnée.

4. Procédé selon la revendication 3, **caractérisé en ce que** la chute de tension (URu) est déterminée au moyen du courant (Iu) qui traverse une résistance à couche épaisse SMD entre le circuit intermédiaire (13) à courant continu et le convertisseur (15).

5. Procédé selon l'une quelconque des revendications 1 à 4, **caractérisé en ce que** le prélèvement du courant sur le réseau est limité en limitant la puissance absorbée par le moteur lorsque le courant efficace prélevé sur le réseau menace de dépasser une valeur limite qui dépend de la réponse d'une protection.
